# EUROPEAN PATENT APPLICATION

(11) **EP 4 644 454 A1**
(43) Date of publication of application: **05.11.2025**
(21) Application number: 23912702.0
(22) Date of filing: 14.12.2023
(51) Int. Cl.: C08G 59/22, C08G 59/24, C08L 63/00, C09D 163/00, H01L 23/29

(54) **HIGH-REFRACTIVE-INDEX AND HIGH-ADHESION EPOXY RESIN COMPOSITION AND ENCAPSULANT COMPRISING SAME**

(30) Priority: 30.12.2022 KR 20220190348
(71) Applicant: Solus Advanced Materials Co., Ltd., Iksan-si, Jeollabuk-do 54588 (KR)
(72) Inventor: LIM, Jongtae, Yongin-si Gyeonggi-do 16858 (KR)
(74) Representative: Office Freylinger
(86) International application number: PCT/KR2023/020706
(87) International publication number: WO 2024/144027

(57) **Abstract**

The present invention relates to a high-refractive and high-adhesion epoxy resin composition and an encapsulation material including the same, and to a high-refractive and high-adhesion epoxy resin composition, which can be applied to various methods of spraying a low-viscosity liquid and filling and curing a gap, such as an inkjet, dispense coating method, or the like, has excellent light extraction efficiency, high adhesion, and low outgassing properties during curing, and can bond and mold glass components of organic or inorganic light-emitting display screen, and an encapsulation material including the same.

## Description

### [Technical Field]

The present invention relates to a high-refractive and high-adhesion epoxy resin composition and an encapsulation material including the same, and to a high-refractive and high-adhesion epoxy resin composition, which can be applied to various methods of spraying a low-viscosity liquid and filling and curing a gap, such as an inkjet, dispense coating method, or the like, has excellent light extraction efficiency, high adhesion, and low outgassing properties during curing, and can bond and mold glass components of organic or inorganic light-emitting display screen, and an encapsulation material including the same.

### [Background Art]

As user's demands, such as high integration, thinness, and miniaturization of displays, change, the properties and use methods of encapsulation materials have been changed physically and chemically. Conventionally, cathode ray tubes with electron beams and fluorescent materials, field light-emitting displays through the light-emission of emitter arrays, plasma display panels using the photoelectric effect of plasma gas, electrical arrangements of liquid crystals, liquid crystal displays using movement, etc. have been widely used in the industry, but their performance and life has varied greatly due to problems, such as the weight of the display itself, the display quality of dynamic screens, heat generation, burn-in, high power consumption, and the like. To improve various disadvantages of these display devices, organic light-emitting diode display devices have been developed since the late 1980s. An organic light-emitting diode display device have lower weight than conventional display devices, excellent readability and contrast ratio, excellent power efficiency, and a fast response speed. However, it is known that the corresponding display device also has weaknesses to burn-in and changes in external temperature and humidity.

Conventionally, to resolve these advantages, a method of enclosing and encapsulating an organic light-emitting display element in heavy glass or a transparent inorganic chamber is used, but this can cause a big problem in the operability, handling reliability, and thinning of the product in the future. A liquid state is the most effective for the user to freely adjust the shape of the display device, and thus, to solve the conventional problems, in the present invention, a material that is beneficial for the development of a display element having excellent light extraction efficiency, high adhesion, and low outgassing properties was developed.

### [Disclosure]

### [Technical Problem]

The present invention is directed to providing a high-refractive and high-adhesion epoxy resin composition, which can be applied to various methods of spraying a low-viscosity liquid and filling and curing a gap, such as an inkjet, dispense coating method, or the like, generates a low level of gas during a curing process, has excellent light extraction efficiency, high adhesion, and low outgassing properties during curing, and can bond and mold glass components of organic or inorganic light-emitting display screen, and an encapsulation material including the same.

### [Technical Solution]

To achieve the above objects, a high-refractive and high-adhesion epoxy resin composition of the present invention includes (a) a high refractive index epoxy resin represented by the following Chemical Formula 1, (b) a high-reliability diluted epoxy resin including a substituted or unsubstituted cycloaliphatic group having 10 to 100 carbon atoms, and (c) a non-yellowish adhesive epoxy resin represented by the following Chemical Formula 2,

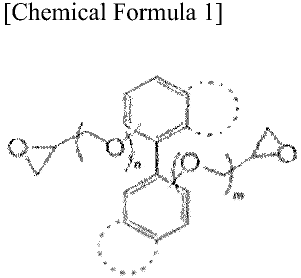

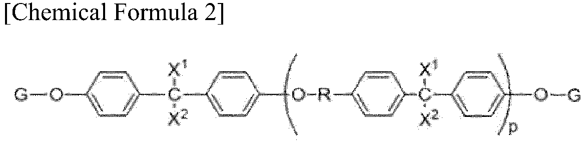

in Chemical Formula 1, the ring indicated by the dotted line is a group fused to an adjacent 6-membered ring structure and is one of a substituted or unsubstituted C6 to C60 monocyclic aryl, a substituted or unsubstituted C6 to C60 condensed ring aryl, a substituted or unsubstituted C6 to C60 aryloxy group, a substituted or unsubstituted C6 to C60 monocyclic heteroaryl group, and a substituted or unsubstituted C6 to C60 condensed ring heteroaryl group, and m and n are, each independently, integers from 0 to 4, but both are not 0, and
in Chemical Formula 2, G is an organic group-containing a glycidyl group, X¹ and X² are, each independently, hydrogen or a methyl group, p is an integer of 1 to 10, and R is a substituted or unsubstituted C10 to C100 alkylene group or alkenylene group

The high-refractive and high-adhesion epoxy resin composition may include 50 to 80 parts by weight of a high-refractive index epoxy resin, 5 to 30 parts by weight of a non-yellowish adhesive epoxy resin, and 10 to 50 parts by weight of a high-reliability diluted epoxy resin.

The high-reliability diluted epoxy resin is prepared by including one or more compounds selected from the group consisting of dicyclopentadiene dioxide, limonene dioxide, 4-vinylcyclohexene dioxide, 2,4-epoxycyclohexylmethyl, 3,4-epoxycyclohexanecarboxylate, dicyclopentadiene dioxide, and bis(3,4-epoxycyclohexylmethyl)adipate, and more preferably, may be prepared by including one or more compounds selected from the group consisting of the following A-1 to A-3,

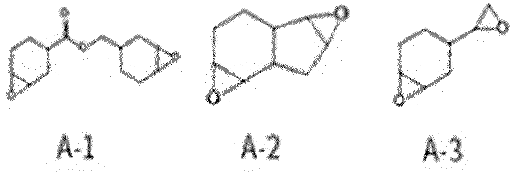

The high-refractive and high-adhesion epoxy resin composition may further include a heat curing agent in an amount of 0.5 to 5.0 parts by weight, and the heat curing agent may be a latent heat curing agent.

The high-reliability diluted epoxy resin may have a liquid refractive index of 1.56 or more and a film refractive index of 1.60 or more.

To achieve the above objects, an encapsulation material for a display device of the present invention may include the high-refractive and high-adhesion epoxy resin composition.

### [Advantageous Effects]

According to the present invention, by having additional excellent optical characteristics as well as having excellent processability, electrical, mechanical, and chemical properties of the conventional liquid epoxy material, the composition user can acquire operability, productivity, and reliability when using the corresponding material.

### [Mode for Invention]

Hereinafter, an epoxy resin composition according to the present invention will be described in more detail.

An epoxy resin is a representative thermosetting resin of which a linear structure has a three-dimensional network structure through a curing process and has excellent physical properties, such as heat resistance, corrosion resistance, adhesion, insulation, and the like, and thus occupies a very important position industrially as an electrical and electronic material. The main reason why such an epoxy resin may be used in the field of electrical and electronic materials is that i) the types of epoxy resins and their curing agents are diverse so that various required physical properties may be provided, ii) the inherent physical properties of the resin, such as excellent adhesion, mechanical properties, chemical resistance, and the like, are excellent, iii) shrinkage deformation occurs less during a curing reaction compared to other thermosetting resins, iv) when being properly formulated as a one-component type product, or when using an appropriate curing agent when being produced as a two-component type product, the shelf life is long, and by-products are not generated during the curing reaction, and iv) transfer molding, coating, casting, manual application, etc. are possible so that complex shapes can be molded, making it suitable for packaging of electrical components.

In addition, in the present invention, by including the following high-refractive epoxy resin, highly reliable dilution epoxy resin, and non-yellowish adhesive epoxy resin, a high-refractive and high-adhesion epoxy resin composition, which maintains the inherent mechanical, chemical, and thermal properties of an epoxy and has excellent light extraction efficiency, high adhesion, and low outgassing properties during curing, was derived.

### (a) High-refractive epoxy resin

The high-refractive epoxy resin according to the present invention is formed by including a monomer represented by the following Chemical Formula 1.

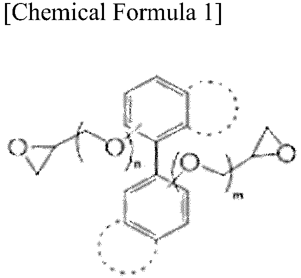

In Chemical Formula 1, the ring indicated by the dotted line is a group fused to an adjacent 6-membered ring structure and is one of a substituted or unsubstituted C6 to C60 monocyclic aryl, a substituted or unsubstituted C6 to C60 condensed ring aryl, a substituted or unsubstituted C6 to C60 aryloxy group, a substituted or unsubstituted C6 to C60 monocyclic heteroaryl group, and a substituted or unsubstituted C6 to C60 condensed ring heteroaryl group, and
m and n are, each independently, an integer of 0 to 4, but are not both 0.

### (b) High-reliability diluted epoxy resin

The high-reliability diluted epoxy resin according to the present invention may be an epoxy resin that is prepared from a compound including a substituted or unsubstituted alkylene group or alkenylene group having 5 to 100 carbon atoms or a cycloaliphatic group and may be preferably an epoxy resin that is prepared from a compound including a cycloaliphatic group.

The compound including a cycloaliphatic group may be selected from the group consisting of dicyclopentadiene dioxide, limonene dioxide, 4-vinylcyclohexene dioxide, 2,4-epoxycyclohexylmethyl, 3,4-epoxycyclohexanecarboxylate, dicyclopentadiene dioxide, and bis(3,4-epoxycyclohexylmethyl)adipate.

More preferably, the cycloaliphatic group may be a compound selected from the group consisting of the following A-1 to A-3,

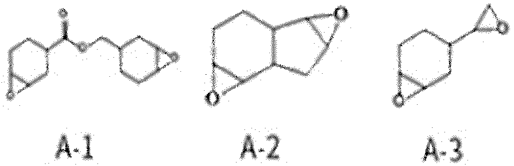

.

The diluted epoxy resin is preferably included in an amount of 10 to 50 parts by weight and is advantageous in controlling viscosity and securing heat resistance within the above content range.

### (c) Non-yellowish adhesive epoxy resin

The non-yellowish adhesive epoxy resin according to the present invention is a bifunctional epoxy resin represented by the following Chemical Formula 2 and may be used to contribute to a curing structure of an epoxy composition, relieve a stress between substrates of a display device, and enhance adhesion between a chip and the substrate.

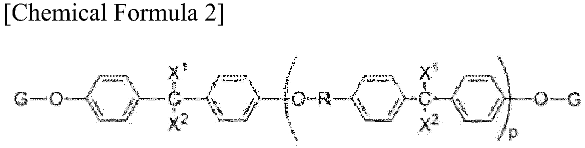

In Chemical Formula 2, G is an organic group-containing a glycidyl group, X¹ and X² are, each independently, hydrogen or a methyl group, p is an integer of 1 to 10, and R is a substituted or unsubstituted C10 to C100 alkylene group or alkenylene group.

As the bifunctional epoxy resin represented by Chemical Formula 2, a diglycidyl ether-based bifunctional epoxy resin is preferable, and specifically, at least one selected from the group consisting of a bisphenol F diglycidyl ether type epoxy resin, a bisphenol A diglycidyl ether type epoxy resin, a polyolefin-added bisphenol A diglycidyl ether type epoxy resin, a polyolefin-added bisphenol F diglycidyl ether type epoxy resin, a 1,6-hexanediol diglycidyl ether type epoxy resin, and a 1,4-butanediol diglycidyl ether type epoxy resin may be used.

In the present invention, the non-yellowish adhesive epoxy resin is preferably included in an amount of 5 to 30 parts by weight. When the content of the non-yellowish adhesive epoxy resin is less than 5 parts by weight, the time for which the product may be used at room temperature is reduced, which may not have the preferable influence on high-temperature and high-humidity reliability. In addition, the inherent hardness of the composition increases too much, making it easy to break, and adhesion is also badly affected, which may not be preferable.

### (d) Heat curing agent

The high-refractive and high-adhesion epoxy resin composition according to the present invention may include a heat curing agent. The heat curing agent is a heat curing polymer, and an appropriate curing agent is required for an epoxy resin to properly perform its function, and the unique characteristics of the epoxy resin are exhibited through a curing reaction using the curing agent. Conventionally, amine, acid, phenol curing agents, etc. were used and have been selectively used to have adhesion, electrical characteristics, and resistance to high-temperature and high-humidity that are distinguished from other plastic materials. A representative reaction between an epoxy resin and an amine curing agent is as follows. The amine curing agent attacks and opens the ring of the epoxy resin, and epoxy-amine molecules that have grown at a specific location attacks the surrounding epoxy resin to cause a chain reaction. The reaction is ended after the amine-attached molecules are almost consumed, and the reaction that forms such a dense structure is called a curing reaction. In this reaction, a hydroxyl group is necessarily generated and has a significant influence on adhesion and the pot life of the product, but also causes poor moisture resistance, unreliability, and cracking.

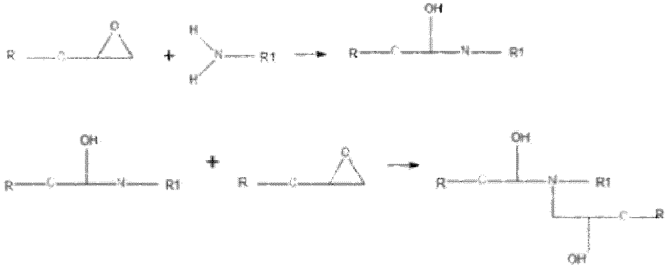

In the present invention, it is preferable to use a latent heat curing agent that causes a direct reaction between epoxy resins as follows. In this reaction, a hydroxyl group does not appear like the above epoxy-amine reaction, and a cured product having a long fiber-like molecular structure can be obtained. Accordingly, unlike the conventional epoxy-curing agent reaction, a structure that is advantageous for long-term reliability can be obtained.

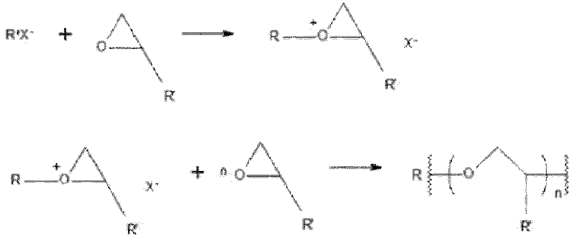

As the latent heat curing agent used herein, any or commercially available curing agent may be used, and specifically, one or more compounds selected from the group consisting of tetradecyl (trihexyl) phosphonium dicyandiamide, 1-butyl-3-methylimidazolium tetrafluoroborate, 1-ethyl-3-methylimidazolium tetrafluoroborate, 1-ethyl-3-methylimidazolium methanesulfonate, tolylcumyl iodo-nium tetrakis (pentafluorophenyl) borate, Opton CP-66, Opton CP-77 (Adeka Japan), 2-ethyl-4 methyl imidazolium tetraphenylborate, tetraphenylphosphonium tetraphenylborate, quaternary ammonium borate, (4-acetoxyphenyl) benzyl (methyl) sulfonium, tetrakis (pentafluorophenyl) borate, SI-B2, SI-B3, SI-B3A, SI-B4, and SI-B7 (Samshin Chemical, Co., Ltd.).

In the present invention, the latent heat curing agent is preferably included in an amount of 0.5 to 5.0 parts by weight, more preferably, 0.5 to 3.0 parts by weight, and even more preferably, 0.5 to 1.5 parts by weight. When the content of the latent heat curing agent is less than 0.5 parts by weight, there is a possibility of uncured products being generated, which is not preferable, and when the content exceeds 1.5 parts by weight, there is a risk of reduced pot life at room temperature or high temperature, problematic heat generation during curing, and sometimes, in the case of a dispensing process, knotting and hardening of the tip of a dispensing needle may be caused to affect the user's use of the product, which is not preferable.

In the present invention, when the physical and chemical properties are exhibited by replacing the latent heat curing agent, a general latent curing agent may be used, and a commercially available product may be used. For example, as the latent curing agent, Ajicure MW-24, Ajicure MW-H, Ajicure PN-23, Ajicure PN-H, Ajicure PN-31, Ajicure PN-40, Ajicure PN-50, VDH, VDH-J, AH-154, ADH, DDH, SAH, IDH, SDH, LDH, UDH, Ankamain 2441, Ankamain 2442, Ankamain 2014AS, Technicure LS-80, Technicure LS-100, Technicure LS-214, Technicure MDU-11, Technicure PDU-250, Technicure IPDU-8, Technicure TDU-200, EH-4357, Novacure HX-3721, Novacure HX-3722, Novacure HX-3748, Novacure HX-3741, Novacure HX-3742, Novacure HX-3088, Novacure HX-3613, Novacure HX-3921 HPE, Novacure HX-3941 HPE, Novacure HX-3932 HPE, FXR-1081, FXR-1020, FXR-1060, etc. may be used, and these may be used alone or in combination of two or more. These latent curing agents have a microcapsule form in which an epoxy resin encapsulates an imidazole curing accelerator, and thus may promote the curing action of an epoxy composition only at a high temperature of 80 to 100 °C or less and contribute to storage stability at room temperature.

### (e) Additive

The epoxy resin composition according to the present invention may optionally further include an additive as needed. The additive may be used to enhance the property of the epoxy composition to flow into a gap between a chip and a substrate and additionally prevent an empty space from being formed in the gap, and for example, BYK 018, BYK 019, BYK 021, BYK 024, BYK 066N, BYK 909, ethoxy ethanol, mono ether glycol polyethylene, etc. may be used, but the present invention is not limited thereto. The materials may be used alone or in combination of 2 or more.

The content of the additive may range from 0.01 to 1.0 parts by weight. When the content of the additive is less than 0.1 parts by weight, the desired effect cannot be obtained, and when the content exceeds 1.0 parts by weight, flowability can increase excessively, resulting in a degradation of physical properties, which is not preferable.

Hereinafter, the present invention will be described in more detail through examples, and the scope of the present invention is not limited to only the following examples.

### [Examples and Comparative Examples; preparation of epoxy resin composition]

A high-refractive epoxy resin, a diluted epoxy resin, and an adhesive epoxy resin were added to a planetary mixer with components and contents of Table 1 below, and stirred at room temperature and room pressure for 2 hours to make them uniform, and then a latent heat curing agent was quantitatively added and stirred at room temperature and room pressure for 2 hours. Then, a viscous liquid was obtained after degassing in a vacuum.

**[Table 1]**

| Mixing ratio (parts by weight) | Example 1 | Example 2 | Comparative Example 1 | Comparative Example 2 | Comparative Example 3 |
|---|---|---|---|---|---|
| D-1⁽¹⁾ | 45.4 | 48.5 | 45.5 | 45.5 | 40 |
| D-2⁽²⁾ | 6.5 | 7 | - | - | 20 |
| D-3⁽³⁾ | - | - | 6.5 | 6.5 | - |
| A-1⁽⁴⁾ | 33 | 29.5 | 33 | 33 | 33 |
| B-1⁽⁵⁾ | 15 | 15 | 15 | - | - |
| B-2⁽⁶⁾ | - | - | - | 15 | - |
| B-3⁽⁷⁾ | - | - | - | - | 15 |
| C⁽⁸⁾ | 1.1 | 1.1 | 1.1 | 1.1 | 1.1 |

| | | | | | |
|---|---|---|---|---|---|
| (1) D-1: 1-functional liquid epoxy resin, 2-biphenylyl glycidyl ether (2) D-2: 2-functional solid epoxy resin, oxirane, 2,2'-[[1,1'-binaphthalene]-2,2'-diylbis(oxymethylene)]bis- (3) D-3: multifunctional liquid epoxy resin, fluorene type epoxy compound (EG-200) (4) A-1: 2-functional liquid epoxy resin, (3',4'-epoxycyclohexane)methyl 3,4-epoxycyclohexylcarboxylate (5) B-1: 2-functional liquid epoxy resin, bisphenol A-bisphenol A diglycidyl ether polymer ] (6) B-2: 2-functional liquid epoxy resin, bisphenol F diglycidyl ether (7) B-3: 2-functional oxetane epoxy resin, bis(1-ethyl(3-oxetanil)methyl) ether (OXT-221) (8) C: latent heat curing agent, phenyl amine borate | | | | | |

### [Basic evaluation of epoxy resin composition]

The results obtained by evaluating the refractive indexes (liquid), cured product refractive indexes (film), viscosity, adhesion, and high temperature stability (40 °C) of the epoxy compositions prepared in Examples 1 and 2 and the epoxy compositions prepared in Comparative Examples 1 to 3 are shown in Table 2.

**[Table 2]**

| | | | | | |
|---|---|---|---|---|---|
| Refractive index (liquid) | 1.56 | 1.57 | 1.56 | 1.56 | 1.55 |
| Refractive index (liquid) | 1.60 | 1.61 | 1.59 | 1.59 | 1.58 |
| Viscosity (mPa·s) | 580 | 610 | 630 | 530 | 1600 |
| Adhesion (kgf/cm²) | 6.5 | 6.5 | 6.0 | 6.0 | 6.0 |
| High-temperature stability (40 °C) | 6 days | 6 days | 4 days | 4 days | 4 days |
| T_{g} | 106 | 101 | 103 | 98 | 94 |
| High vacuum weight reduction(%) | -0.2 | -0.2 | -0.2 | -0.7 | -0.7 |

| | | | | | |
|---|---|---|---|---|---|
| 1. Refractive index (liquid): measure the refractive index of the epoxy composition at 25±5 °C using an Abbe refractometer. 2. Refractive index (film): measure the refractive index in a thickness direction and surface direction by bonding a thin film to a prism and changing an incident angle of a laser beam and measure the refractive index using 2010/M from Metricon. 3. Viscosity: measure viscosity at 25±5 °C using Brookfield DV2T viscometer and cone and plate type CPA-51Z spindle and record viscosity after 30 minutes. 4. Adhesion: coat a glass plate of 76 mm × 26 mm × 3 mm with 0.01g of epoxy composition, then press, cure the glass plate in an oven set as 100 °C for 60 minutes, and then measure adhesion using UTM. 5. High temperature stability (40 °C): fill a glass bottle sealed with a rubber stopper with an epoxy composition and nitrogen gas, leave it at 40±5 °C, measure viscosity every day, and record viscosity when a viscosity change rate was 1.2 times or less more than initial viscosity | | | | | |

As shown in Table 2, it can be confirmed that the epoxy compositions manufactured in Examples 1 and 2 of the present invention have a liquid refractive index of 1.56 or more and a film refractive index of 1.60 or more, a suitable viscosity level, high adhesion, and good storage stability. In particular, as in Examples 1 and 2, the refractive index tended to increase as D-2 was used. In addition, in Examples 1 and 2 using B-1, high-temperature stability tended to increase. From the above physical property evaluation, it was confirmed that the epoxy resin compositions of Examples 1 and 2 could be usefully used as an encapsulation material composition for a display device.

As described above, since specific parts of the present invention have been described in detail, it will be apparent to those skilled in the art that such specific description is merely an exemplary embodiment and the scope of the present invention is not limited. Accordingly, the actual scope of the present invention will be defined by the appended claims and their equivalents.

## Claims

1. A high-refractive and high-adhesion epoxy resin composition comprising:
(a) a high refractive index epoxy resin represented by the following Chemical Formula 1;
(b) a high-reliability diluted epoxy resin including a substituted or unsubstituted cycloaliphatic group having 10 to 100 carbon atoms; and
(c) a non-yellowish adhesive epoxy resin represented by the following Chemical Formula 2, 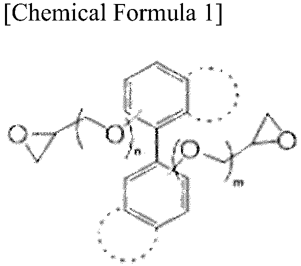 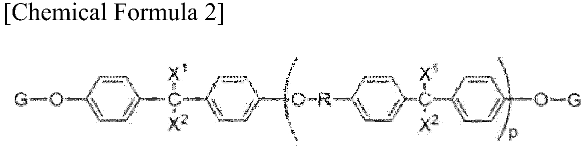
in Chemical Formula 1, the ring indicated by the dotted line is a group fused to an adjacent 6-membered ring structure and is one of a substituted or unsubstituted C6 to C60 monocyclic aryl, a substituted or unsubstituted C6 to C60 condensed ring aryl, a substituted or unsubstituted C6 to C60 aryloxy group, a substituted or unsubstituted C6 to C60 monocyclic heteroaryl group, and a substituted or unsubstituted C6 to C60 condensed ring heteroaryl group, and m and n are, each independently, integers from 0 to 4, but both are not 0, and
in Chemical Formula 2, G is an organic group-containing a glycidyl group, X¹ and X² are, each independently, hydrogen or a methyl group, p is an integer of 1 to 10, and R is a substituted or unsubstituted C10 to C100 alkylene group or alkenylene group.

2. The high-refractive and high-adhesion epoxy resin composition of claim 1, comprising: 50 to 80 parts by weight of a high-refractive index epoxy resin; 5 to 30 parts by weight of a non-yellowish adhesive epoxy resin; and 10 to 50 parts by weight of a high-reliability diluted epoxy resin.

3. The high-refractive and high-adhesion epoxy resin composition of claim 1, wherein the high-reliability diluted epoxy resin is prepared by including one or more compounds selected from the group consisting of dicyclopentadiene dioxide, limonene dioxide, 4-vinylcyclohexene dioxide, 2,4-epoxycyclohexylmethyl, 3,4-epoxycyclohexanecarboxylate, dicyclopentadiene dioxide, and bis(3,4-epoxycyclohexylmethyl)adipate.

4. The high-refractive and high-adhesion epoxy resin composition of claim 1, wherein the high-reliability diluted epoxy resin is prepared by including one or more compounds selected from the group consisting of the following A-1 to A-3,

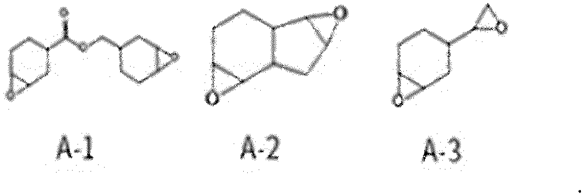

5. The high-refractive and high-adhesion epoxy resin composition of claim 1, further comprising a heat curing agent.

6. The high-refractive and high-adhesion epoxy resin composition of claim 5, wherein the heat curing agent is a latent heat curing agent.

7. The high-refractive and high-adhesion epoxy resin composition of claim 1, wherein the high-reliability diluted epoxy resin has a liquid refractive index of 1.56 or more and a film refractive index of 1.60 or more.

8. An encapsulation material for a display device comprising the high-refractive and high-adhesion epoxy resin composition according to any one of claims 1 to 7.
